# EUROPEAN PATENT SPECIFICATION

(11) **EP 2 852 270 B1**
(45) Date of publication and mention of the grant of the patent: **25.11.2020**
(21) Application number: 12876818.1
(22) Date of filing: 15.05.2012
(51) Int. Cl.: H05K 13/02, H05K 13/04

(54) **ELECTRONIC COMPONENT MOUNTING MACHINE**
MASCHINE ZUR MONTAGE VON ELEKTRONISCHEN BAUTEILEN
MACHINE DE MONTAGE DE COMPOSANT ÉLECTRONIQUE

(43) Date of publication of application: 25.03.2015
(73) Proprietor: FUJI Corporation, Chiryu Aichi (JP)
(72) Inventor: NOZAWA, Mizuho, Chiryu Aichi (JP); KATSUMI, Hiroshi, Chiryu Aichi (JP)
(74) Representative: Grünecker Patent- und Rechtsanwälte PartG mbB
(86) International application number: PCT/JP2012/062357
(87) International publication number: WO 2013/171836

(56) References cited:
- WO-A1-2011/046107
- JP-A- H09 307 283
- JP-A- 2000 277 983
- JP-A- 2002 280 793
- JP-A- 2002 280 793
- JP-A- 2005 101 342
- JP-A- 2008 270 332
- JP-A- 2008 311 509
- US-A- 5 852 869
- US-A1- 2002 124 393
- US-B1- 6 588 096

## Description

### Technical Field

The present invention relates to an electronic component mounter for mounting electronic components supplied by a bulk feeder onto a circuit board which is equipped with a bulk feeder and a mounting head.

### Background Art

Bulk feeders are usually configured to supply electronic components to a supply position, and are equipped with a storage section for storing multiple electronic components in a loose state, and a supply passage for guiding the electronic components stored in that storage section to an electronic component supply position while arranged in a single line. Bulk feeders as disclosed in JP 2000-22388 A are an example of feeders configured in that way, and are capable of supplying in order a relatively large quantity of electronic components. Also, there are items configured such that equipped on the mounting head are multiple suction nozzles, a holding body for holding those multiple suction nozzles arranged on a circumference, and a holding body rotating device for rotating that holding body; in order to pick up and hold multiple electronic components with the multiple suction nozzles and mount the electronic components on a circuit board in order.

JP 2002-280793 A proposes to provide an electronic component placement machine that can greatly efficiently place electronic components. In the electronic component placement machine, a movement electronic component supply apparatus is provided. The movement electronic component supply apparatus includes a pickup section where a suction nozzle section can descend for approaching, an accommodation section for accommodating the electronic components, and a supply section for successively supplying the electronic components that are accommodated into the accommodation section to the pickup section, and is supported by a head for freely moving with the head.

WO 2011/046107 A1 discloses an electronic component mounter according to the preamble of independent claim 1.

### Summary of Invention

### Problem to be Solved by the Invention

With bulk feeders with the above configuration it is possible to supply in order a relatively large amount of electronic components, and with mounting heads with the above configuration it is possible to mount multiple electronic components in order on a circuit board, therefore development of electronic component mounters is progressing with a bulk feeder fixedly connected to a mounting head. With electronic component mounters with this kind of configuration, because the bulk feeder is also moved together with the mounting head by the moving device for moving the mounting head to any position, it is possible to drastically reduce the time required to pick up and hold an electronic component with a suction nozzle. However, for electronic component mounters with a bulk feeder fixedly connected to a mounting head, development is still ongoing and there remain many areas for improvement. It follows that, by implementing various improvements, the practicality of that electronic component mounter can be improved. The present invention is an item which takes account of such circumstances and relates to a highly practical electronic component mounter.

### Means for Solving the Problem

In order to solve the above problems, an electronic component mounter according to claim 1 is provided. Preferred embodiments are set out in the dependent claims.

### Summary of Invention

With the electronic component mounter according to claim 1, the widthwise direction of the supply passage of the bulk feeder at the supply position and the direction extending in a tangential line at the pickup position of the circumference arranged on which are multiple suction nozzles are aligned, or the directional deviation of those two is less than 45 degrees. By this, the deviation angle between the rotational direction of the holding body for holding multiple suction nozzles and the width direction of the supply passage at the supply position, in other words, the width direction of the electronic component positioned at the supply position, is made to be relatively small. Also, electronic components are usually generally cuboid, and are stored in the supply passage in an orientation with their lengthwise direction extending in the lengthwise direction of the supply passage. Due to this, by finely adjusting the rotational position of the holding body using the holding body rotating device, suction nozzles are moved in the width direction of the electronic component and the pickup position is adjusted in the width direction of the electronic component. Conversely, the deviation between the pickup position by the suction nozzle and the supply position of the bulk feeder, as described in detail below, depends on the length in the lengthwise direction of the electronic component, and there is a certain degree of tolerance in the direction in which the supply passage extends. It follows that, with the electronic component mounter according to claim 1, in cases in which the pickup position by the suction nozzle and the supply position of the bulk feeder deviate, an electronic component can be picked up appropriately by a suction nozzle just by adjusting the pickup position by a suction nozzle in the width direction of the electronic component using the holding body rotating device. The width direction of an electronic component is the direction perpendicular with respect to the lengthwise direction, the so-called short direction, which is the direction extending along the shortest edge of the edges of the electronic component.

Also, with the electronic component mounter according to claim 1, operation of the holding body rotating device is controlled such that from among the multiple suction nozzles, the suction mouth of the suction nozzle which is positioned at the pickup position is positioned above the supply position. By this, it is possible to perform correction of the pickup position appropriately.

Also, with the electronic component mounter according to claim 2, from among the multiple suction nozzles, a suction nozzle positioned at a position other than the pickup position is configured to mount an electronic component on a circuit board, and the mounting position of electronic components on the circuit board is corrected by operation of the moving device for moving the mounting head to any position being controlled. When the pickup position is corrected by adjustment of the rotational position of the holding body, suction nozzles which perform mounting work are also moved, and the mounting position by those suction nozzles is also moved undesirably. In other words, the position at which mounting work is performed is undesirably deviated from the position at which an electronic component should be mounted on the circuit board due to the correction of the pickup position. Due to this, with the electronic component mounter according to claim 3, the position of the mounting head is finely adjusted by the moving device, the mounting position is corrected, and it is possible to appropriately prevent deviation of the mounting position due to correction of the pickup position.

Also, with the electronic component mounter according to claim 3, pickup work and mounting work are performed at the same time. By this, it is possible to perform mounting work efficiently. However, there are cases in which there is deviation in the up/down direction between the pickup position by a suction nozzle and the mounting position to the circuit board, and cases in which the length of the two work times differs. Also, there are cases in which the length of the two work times differs due to constructional variance between a suction nozzle which performs pickup work and a suction nozzle which performs mounting work. Due to this, for the situation described here, not only is this the situation when the start time and finish time of the two works is the same, also included are situations in which at least a portion of the time during which pickup work is being performed and the time during which mounting work is being performed overlap. In other words, "at the same time" here includes the notion of "approximately at the same time".

Also, with the electronic component mounter according to claim 4, each multiple suction nozzle can be rotated about its own axis at the same time. In other words, it is possible to rotate all of the multiple suction nozzles with the operation of one moving device. By this, it is possible to adjust the holding orientation of electronic components while they are being mounted on a circuit with a rotating device which has a relatively simple configuration. However, when the holding orientation of electronic components to be mounted on a circuit board are adjusted, not only suction nozzles to perform mounting work, but also suction nozzles to perform pickup work are rotated. Due to this, in cases in which the suction mouth of a suction nozzle is of an eccentric shape with respect to the suction nozzle rotational center, specifically, for example, an ellipse or a rectangle, there is a risk that a section of the suction mouth will deviate from the electronic component by the rotation of the suction nozzle, and that an electronic component will not be picked up appropriately. By taking account of this, with the electronic component mounter according to claim 5, the suction mouth of each of the suction nozzles is circular. By this, even if pickup nozzles are rotated, so long as the suction mouth is circular, there will be no risk of deviation from the electronic component and electronic components will be able to be placed appropriately.

Also, with the electronic component mounter according to claim 5, each suction nozzle is moved up from the placement position until the pickup position based on the rotation of the holding body holding the multiple suction nozzles. Due to this, it is possible to move a suction nozzle which is to perform pickup work up, such that it is possible to arrange the supply passage of the bulk feeder under that suction nozzle. By this, it is possible for the bulk feeder to be created in a compact way in the up/down direction of the fixedly connected mounting head. Also, the suction nozzle positioned in the pickup position is configured not to move in the up/down direction even when the holding body is rotated. In other words, even when the holding body is rotated when correcting the pickup position, the up/down movement of the pickup nozzle for correction is limited. By this, it is possible to perform suitable correction of the pickup position.

With the electronic component mounter according to claim 6, the widthwise direction of the supply passage at the supply position and the direction extending in a tangential line at the position on the side of the mounting position from the pickup position of the circumference are aligned. In other words, the situation described here is limited to situations in which the deviation between the widthwise direction of the supply passage at the supply position and the direction extending in a tangential line at the pickup position of the circumference is less than 45 degrees.

### Brief Description of Drawings

[FIG. 1] This is a perspective view showing an electronic component mounter machine configured from two electronic component mounters of the embodiment of the present invention arranged side by side.
[FIG. 2] This is a perspective view showing a mounting head used by an electronic component mounter.
[FIG. 3] This is a perspective view showing the mounting head and the bulk feeder attached to that mounting head.
[FIG. 4] This is a bottom view showing the mounting head as seen from below.
[FIG. 5] This is a perspective view showing the bulk feeder.
[FIG. 6] This is a side view showing the bulk feeder.
[FIG. 7] This is a cross section of line AA shown in FIG. 6.
[FIG. 8] This is a cross section of line BB shown in FIG. 6.
[FIG. 9] This is a schematic drawing showing the positional relationship between the multiple suction nozzles of the mounting head and the supply passage of the bulk feeder.
[FIG. 10] This is a perspective view showing a suction nozzle while picking up an electronic component which has been indexed to the supply position.
[FIG. 11] This is a block diagram showing the control device which is provided on the electronic component mounter.
[FIG. 12] This is a schematic drawing showing when the suction nozzle and electronic component are deviated in the widthwise direction of the electronic component.
[FIG. 13] This is a schematic drawing showing when the suction nozzle and electronic component are deviated in the lengthwise direction of the electronic component.
[FIG. 14] This is a schematic drawing showing an electronic component to be picked up using a suction nozzle with an elliptical suction mouth.
[FIG. 15] This is a schematic drawing showing the positional relationship between the multiple suction nozzles and the supply passage of the bulk feeder when the holding orientation of an electronic component for which mounting work is to be performed has been adjusted.
[FIG. 16] This is a schematic drawing showing an electronic component to be picked up using that suction mouth when the suction nozzle with an elliptical suction mouth has been rotated.
[FIG. 17] This is a chart showing conceptually the change over time of the up/down position of the suction nozzle at the mounting station and the pickup station, and the operating state of the holding body rotating device and unit rotating device when an elliptical suction mouth is used.
[FIG. 18] This is a chart showing conceptually the change over time of the up/down position of the suction nozzle at the mounting station and the pickup station, and the operating state of the holding body rotating device and unit rotating device when a round suction mouth is used. Description of Preferred Embodiments
The following describes in detail referring to the figures, as an embodiment for carrying out the present invention, an example embodiment for the present invention.

### Electronic component mounter machine configuration

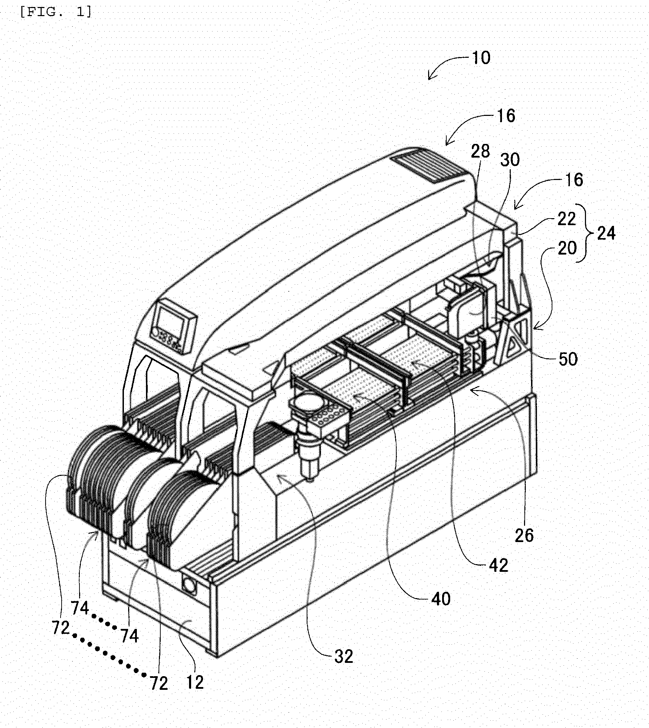

Electronic component mounter machine (hereafter in some cases abbreviated to "mounter machine") 10 is shown in FIG. 1. That figure is a perspective view with some sections of the external parts of mounter machine 10 omitted. Mounter machine 10 is configured including one system base 12 and two electronic component mounters (hereafter in some cases abbreviated to "mounter") 16 arranged lined up side by side adjacent to each other on that system base 12, and is used to perform the mounting operation of electronic components on a circuit board. For the description below, the direction in which mounters 16 are lined up side by side is referred to as the X-axis direction and the horizontal direction perpendicular to that direction is the Y-axis direction.

Each mounter 16 equipped on mounter machine 10 comprises, mainly, mounter main body 24 configured including frame 20 and beam 22 mounted above that frame 20; conveyance device 26 for conveying circuit boards in the X-axis direction as well as securing them in a specified position; mounting head 28 for performing mounting operation on the circuit board secured by the conveyance device 26; moving device 30 for moving mounting head 28 attached to beam 22 in the X-axis direction and Y-axis direction; and electronic component supply device (hereafter in some cases abbreviated to "supply device") 32 for supplying electronic components positioned at the front of frame 20.

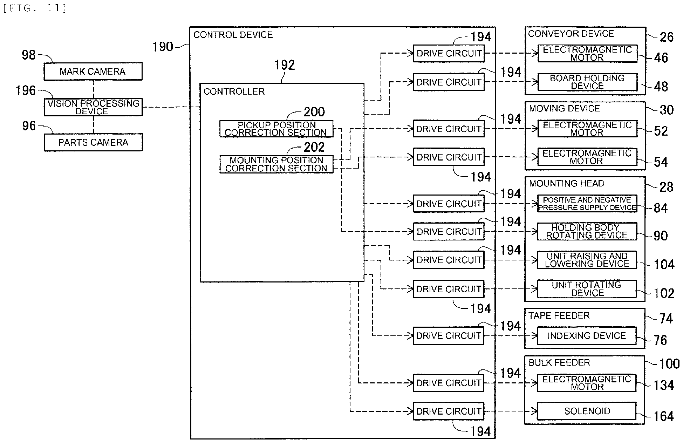

Conveyance device 26 comprises two conveyor devices 40 and 42 and those two conveyor devices 40 and 42 are positioned in the center of the Y-axis direction of frame 20 so that they are parallel to each other and extend in the X-axis direction. Each of the two conveyor devices 40 and 42, as well as conveying circuit boards held by conveyor devices 40 and 42 in the X-axis direction using electromagnetic motor (refer to FIG. 11) 46, are configured to hold circuit boards securely in a specified position by board holding device (refer to FIG. 11) 48.

Moving device 30 is an XY-robot type moving device, and comprises an electromagnetic motor (refer to FIG. 11) 52 for sliding slider 50 which holds mounting head 28 in the X-axis direction; and an electromagnetic motor (refer to FIG. 11) 54 for sliding in the Y-axis direction; by operating these two electromagnetic motors 52 and 54, it is possible to move mounting head 28 to any position on frame 20.

Supply device 32 is positioned on the front end of frame 20 and is a feeder type supply device. Supply device 32 has multiple tape feeders 74 which house taped components which are electronic components that have been taped which are in a wound state on reels 72, and multiple indexing devices (refer to FIG. 11) 76 which index taped components which are housed in each of those multiple tape feeders 74, and is configured to supply consecutively electronic components from taped components to the supply position.

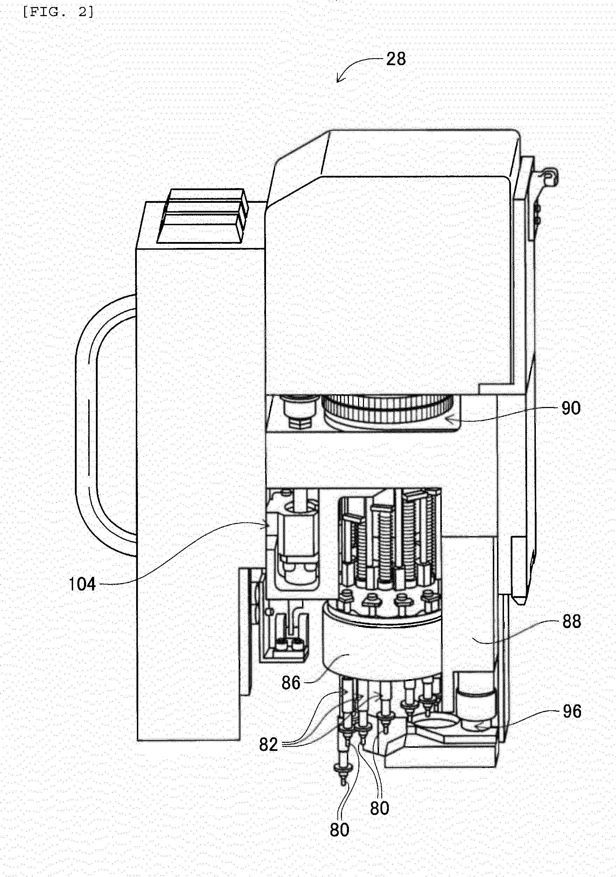

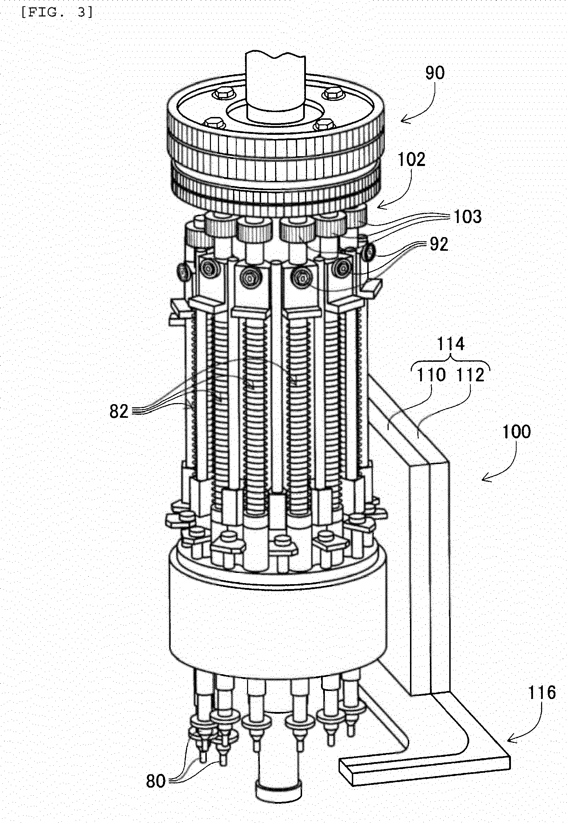

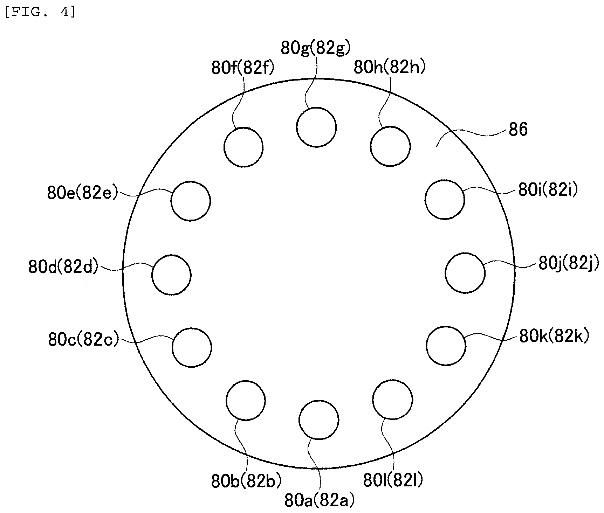

Mounting head 28 is for mounting electronic components on a circuit board held by conveyor device 26, and, as shown in FIGS. 2 to 4, is equipped with twelve mounting units 82 for holding at the tip suction nozzles 80 for picking up electronic components. Also, FIG. 2 is a perspective view showing mounting head 28 in a state removed from slider 50, and FIG. 3 is a perspective view showing mounting head 28 in a state with the covers removed. Also, FIG. 4, is a bottom view of mounting head 28 showing mounting head 28 as seen from below.

Suction nozzles 80 are each configured, through positive and negative pressure supply device (refer to FIG. 11) 84 and via negative pressure air and positive pressure air paths, to hold by suction electronic components using negative pressure, and release the electronic components being held by a small amount of positive pressure being supplied. Mounting units 82 which generally take the form of shafts are held in a state so that the axis direction is vertical at a pitch of equal angles on the outer circumference section of unit holding body 86, and suction nozzles 80, as shown in FIG. 4, extend in twelve equally distributed positions in the downward direction from the bottom surface of unit holding body 86 and are arranged on a circumference.

Unit holding body 86 is supported by head body 88 of mounting head 28 so that it is capable of being rotated about a vertical axis line of itself, and is capable of being rotated to any angle by holding body rotating device 90. By this, multiple suction nozzles 80 arranged on a circumference are capable of being rotated to any angle with the center of the circumference as the axis center.

Rollers 92 are equipped to function as a cam follower at the top section of each mounting unit 82, and each roller 92 is engaged with the cam surface of the cam (omitted from figure) fixed to head body 88. This cam surface is configured so that the height in the circumference varies. Also, each mounting unit 82 is held on unit holding body 86 so that it is capable of moving up and down. By this, mounting units 82 move up and down based on the rotation of unit holding body 86.

In detail, mounting unit 82 located at the mounting station (the station located furthest to the front) which is the stopping position furthest from head body 88 among the multiple stopping positions of mounting units 82 moves furthest down. In other words, when mounting head 28 is moved above a circuit board, the distance between suction nozzle 80 of mounting unit 82 located at that station and the circuit board is at its shortest, and an electronic component is mounted on the circuit board by suction nozzle 80 of that mounting station.

Also, the station positioned directly opposite across the axis center of unit holding body 86 of that mounting station, in other words, the mounting unit 82 located at the imaging station (the station located furthest to the rear) which is the stopping position closest to head body 88, and the four mounting units 82 which are located two each on either side to the left and right of that mounting unit 82, move furthest up. In other words, five mounting units 82 centered around mounting unit 82 located at the imaging station move furthest up.

Head body 88, as shown in FIG. 2, extends lower than the bottom tip of suction nozzle 80 of each mounting unit 82 which is located furthest up and bends to the suction nozzle 80 side. Parts camera 96 is arranged on that portion which is bent, and an image is captured by parts camera 96 of the electronic component being held on suction nozzle 80 of mounting unit 82 located at the imaging station. Also, on the lower surface of the portion on which parts camera 96 is arranged, mark camera (refer to FIG. 11) 98 is arranged in a state facing down, and by being moved by moving device 30, images are capable of being captured at any position on frame 20.

Here, the positional relationship of each station is described using FIG. 4. When mounting unit 82a which is one out of the twelve mounting units 82a to 821 is located at the mounting station, in other words when mounting unit 82a is moved furthest down, five mounting units 82e to 82i are moved furthest up and mounting unit 82g is located at the imaging station. Further, when unit holding body 86 rotates in the normal direction, unit holding body 86 rotates in the clockwise direction in FIG. 4.

Also, the station at which mounting unit 82e which of the five mounting units 82e to 82i is furthest downstream in the rotation direction of unit holding body 86 is located, is the pickup station for picking up electronic components supplied from bulk feeder (refer to FIG. 3) 100 which is described in detail later. Further, electronic components supplied from tape feeders 74 are picked up by suction nozzle 80a of mounting unit 82a located at the mounting station.

Also, mounting head 28 has unit rotating devices 102 for rotating each mounting unit 82 about its own center axis respectively at the same time. As shown in FIG. 3, unit rotating device 102 is configured from multiple gears 103 provided at the top end of multiple mounting units 82 and one gear (omitted from the figure) which engages with those multiple gears 103, and by those multiple gears 103 rotating due to the rotation of the one gear, each mounting unit 82 rotates around its own axis at the same time. By this, it is possible to change the holding orientation of electronic components being held by each mounting unit 82. Also, mounting head 28 is provided with unit raising and lowering device 104 for raising and lowering individually mounting units 82 which are located at the mounting station and pickup station, and mounting units 82 are moved to any position in the vertical direction when electronic components are mounted and picked up.

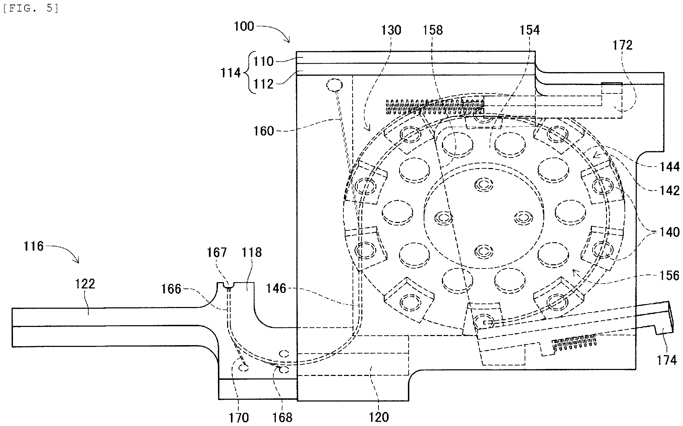

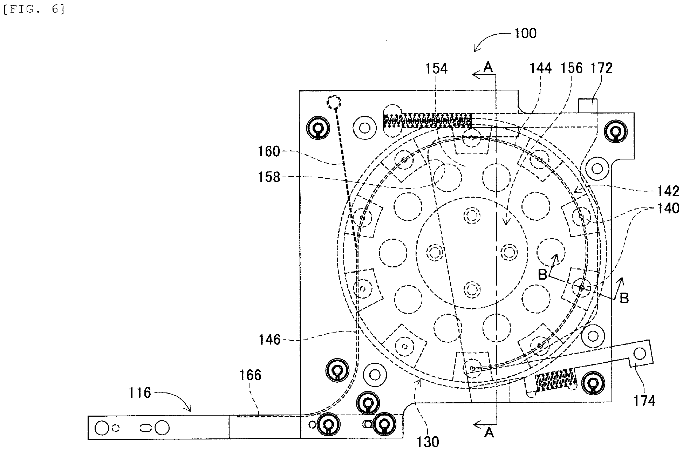

Also, bulk feeder 100 which supplies electronic components to the mounting unit 82 positioned at the pickup station is attached to head body 88 of mounting head 28 and is capable of being moved to any position on frame 20 along with mounting head 28 by moving device 30. As shown in FIG.5 and FIG. 6, bulk feeder 100 has housing 114 which is two case members 110 and 112 fitted reciprocally together, and arm member 116 fastened by bolts to head body 88 and secured to the bottom end of housing 114.

Arm member 116 is divided into number 1 arm section 118 which reaches lower than mounting unit 82 located at the pickup station, number 2 arm section 120 which is orthogonal while being in the same horizontal plane as number 1 arm section 118, and number 3 arm section 122 which is orthogonal while being in the same horizontal plane as number 1 arm section 118 and which extends in the opposite direction to number 2 arm section 120. Arm member 116 is fastened by bolts to head body 88 at number 3 arm section 122, and is fastened by bolts to housing 114 at number 2 arm section 120.

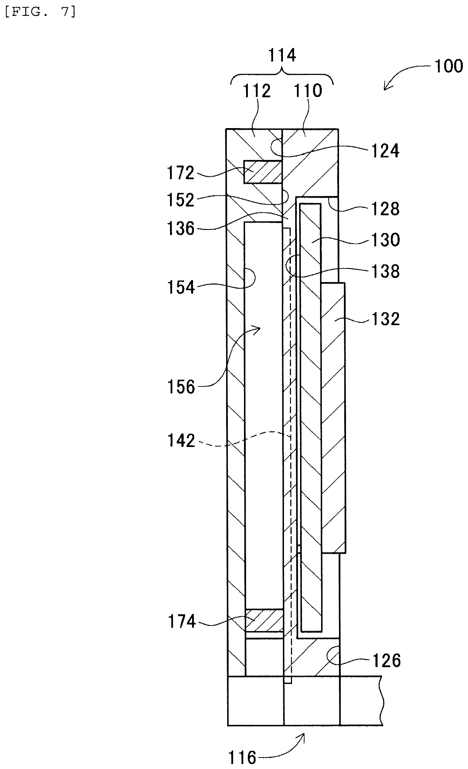

The two case members 110 and 112 which make up housing 114 are tabular plates and are established in a state with their respective surfaces fitted together. As shown in FIG. 7 which is a cross section along the line AA of FIG. 6, fitting surface 124 to which case member 112 is fitted and recess section 128 which opens in surface 126 on the opposite side are formed on case member 110, and turntable 130 is provided inside that recess section 128.

Turntable 130 is disc shaped and is held on case member 110 such that it is capable of being rotated around its center axis. Rotation movement device 132 is provided on turntable 130 and turntable 130 is controllably rotated by the movement of electromagnetic motor (refer to FIG. 11) 134 of rotation movement device 132. Further, when turntable 130 is rotated in the normal direction, turntable 130 shown in FIG. 6 rotates in the counterclockwise direction.

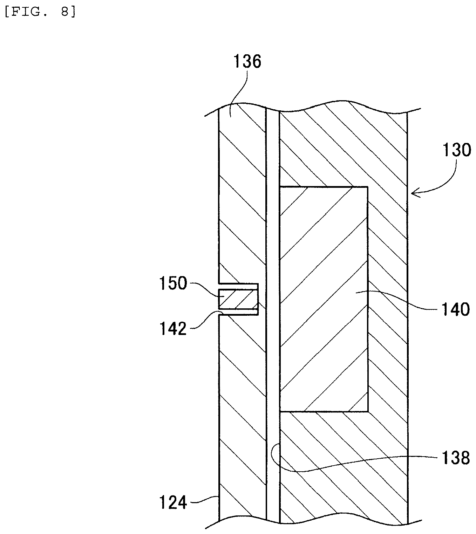

As shown in FIG. 8 which is a cross section along line BB of FIG. 6, permanent magnet 140 is embedded in the opposite surface 138 of turntable 130 facing base section 136 of recess section 128 formed in case member 110. As shown in FIG. 6, ten permanent magnets 140 are embedded near the outer edge section of turntable 130, and the ten permanent magnets 140 are positioned evenly.

Also, on base section 136 of recess section 128, groove 142 is formed in fitting surface 124 which is the surface on the opposite side of the surface facing turntable 130. As shown in FIG. 6, groove 142 is divided into annular groove section 144 which is a portion that is annular with the rotational axis line of turntable 130 as its center and vertical groove section 146 which is connected to that annular groove section 144 and extends continuously generally in the vertical direction.

Annular groove section 144 is formed in the position following the rotation path of the ten permanent magnets 140 based on the rotation of turntable 130, and extends in the rotation direction of the normal rotation of turntable 130 from the lowest point of the rotation path of permanent magnets 140, via the highest point of the rotation path of permanent magnets 140, and arrives at the foremost end (the end point on the side of arm member 116). On the other hand, vertical groove section 146 connects on from the foremost end extending down of annular groove section 144 and extends down. And, it is curved to the front (in the direction towards arm member 116), and open to the side surface of the front of case member 110 in a state which is generally horizontal.

Inside groove 142, as well as electronic components being housed while the longitudinal direction thereof extends in the longitudinal direction of groove 142, multiple electronic components are housed in a state arranged in a single line in the longitudinal direction of each thereof. As shown in FIG. 8, the depth of groove 142 is slightly larger than the width of electronic component 150, and the width of groove 142 is slightly larger than the thickness of electronic component 150. And, electronic components 150 are housed in groove 142 so that the thickness direction is in the width direction of groove 142.

Also, on case member 112, as shown in FIG. 7, recess section 154 which opens and is formed in fitting surface 152 which is fitted to fitting surface 124 in which groove 142 is formed. In detail, recess section 154, as shown in FIG. 6, is generally semicircular and is formed in a state extending backwards from a section of the rotational axis line of turntable 130 and annular groove section 144, specifically, the lowest point of annular groove section 144, and covering the portion reaching the highest point. Further, two case members 110 and 112 are fitted together by respective fitting surfaces 124 and 152, and electronic component storage section 156 is formed by the opening of the recess section 154 being blocked by base section 136. In other words, storage section 156 is bounded by recess section 154 of case member 112 and base section 136 of case member 110.

The portion covered by recess section 154 of annular groove section 144 is open to the inside of recess section 154, in other words, storage section 156. Also, annular groove section 144, as given above, is formed along the rotation path of permanent magnets 140. Due to this, electronic components housed in storage section 156 are housed in annular groove section 144 by the magnetic force of permanent magnets 140. Further, by rotating turntable 130 in the normal direction via the movement of rotation movement device 132, electronic components housed in annular groove section 144 are moved in the rotational direction of turntable 130.

However, the portion not covered by recess section 154 of annular groove section 144 is blocked by fitting surface 152 of case member 112, so that the cross section is a rectangular tunnel. Due to this, when electronic components housed in annular groove section 144 reach the tunnel shaped annular groove section 144 in accordance with the rotation of turntable 130, electronic components which protrude from annular groove section 144 are prevented from entering into tunnel shaped annular groove section 144 by side wall 158 of recess section 154.

Specifically, side wall 158 which is located at the diameter section of semicircular recess section 154 is established perpendicular with respect to fitting surface 124 formed in groove 142, and the upper end section of side wall 158 is located near the highest point of annular groove section 144. And, annular groove section 144 located upstream of side wall 158 opens onto storage section 156, and annular groove section 144 located downstream of side wall 158 is tunnel shaped. Due to this, electronic components protruding from annular groove section 144 contact side wall 158 near the highest point of annular groove section 144 and are prevented from being indexed from storage section 156. By this, it is possible to only index from storage section 156 electronic components which are appropriately housed in annular groove section 144. Further, case member 112 is formed out of semi-transparent material so that items such as storage section 156 and annular groove section 144 can be checked visually from outside.

Also, air groove 160 for supplying air is formed in fitting surface 124 which is formed in groove 142 formed from annular groove section 144 and vertical groove section 146. This air groove 160 is formed to extend in the vertical direction, and the lowest section thereof is connected to the boundary portion of annular groove section 144 and vertical groove section 146. Air groove 160, at the uppermost section, is linked to an air passage (omitted from figure) which is connected to an air supply device (omitted from figure), so that compressed air can be blown downwards inside air groove 160. Also, the air passage is provided with an opening and closing valve (omitted from figure), and the supply and blocking of air can be controlled by controlling solenoid (refer to FIG. 11) 164 of the opening and closing valve.

Also, on arm member 116, as shown in FIG. 5, as well as opening on the upper surface, groove 166 connected to vertical groove section 146 open the side surface of the front of case member 110 is formed. Groove 166 is bent towards number 1 arm section 118 and extends to the end surface of number 1 arm section 118. Pin 167 is established on the inside of groove 166 of the upstream side of that end surface, and electronic components indexed inside groove 166 are stopped by that pin 167. In other words, the location at which pin 167 is established is the supply position for electronic components of bulk feeder 100.

On arm member 116, as well as opening on the upper surface, also formed are two air grooves 168 and 170 connected to the curved portion of groove 166. The above air passage is also connected to these air grooves 168 and 170, so that compressed air is blown inside groove 166 towards the end surface of number 1 arm section 118. Further, air groove 168 is connected to the end section of the upstream side of the curved portion of groove 166, and air groove 170 to the end section of the downstream side of the curved portion of groove 166. By this, electronic components indexed in groove 166 are not allowed to accumulate in the bent section.

Further, the upper surface of arm member 116 is covered by a cover (omitted from figure) and groove 166 and air grooves 168 and 170 are tunnel shaped. Also, a cutout section (omitted from figure) is formed in the position covering the supply position for electronic components of number 1 arm section 118, and supply of electronic components is performed via that cutout section. Further, the cover is formed from semi-transparent material so that groove 166 and air grooves 168 and 170 can be checked visually from outside.

Also, storage section 156 for storing electronic components, in other words, recess section 154 formed in case member 112, is open to the upper surface and lower surface of case member 112, and shutters 172 and 174 are provided on those openings respectively. Opening and closing is made possible by sliding each shutter 172 and 174, and by opening shutter 172 it is possible to replenish electronic components inside storage section 156, and by opening shutter 174 it is possible to evacuate electronic components stored in storage section 156 outside of bulk feeder 100.

With bulk feeder 100 configured as given above, electronic components are stored inside storage section 156 in a loose state, and those multiple electronic components stored in a loose state are indexed to a supply position while arranged in a single line. Specifically, electronic components housed in storage section 156 are taken into annular groove section 144 by the magnetic force of permanent magnets 140. Further, by rotating turntable 130 in the normal direction via the movement of rotation movement device 132, electronic components taken into annular groove section 144 are moved in the rotational direction of turntable 130. During this, multiple electronic components come to be arranged in a single line inside annular groove section 144.

When electronic components housed in annular groove section 144 reach the tunnel shaped annular groove section 144 in accordance with the rotation of turntable 130, electronic components which protrude from annular groove section 144 contact side wall 158 of recess section 154. By this, electronic components which contact side wall 158 drop to the bottom of storage section 156 and only electronic components which are appropriately housed in annular groove section 144 are moved inside annular groove section 144 in accordance with the rotation of turntable 130.

In accordance with the rotation of turntable 130, electronic components are moved from inside annular groove section 144 to inside vertical groove section 146. And, although electronic components move down by their own weight inside vertical groove section 146, they are indexed to groove 166 through the inside of vertical groove section 146 by air which is blown inside vertical groove section 146 from air groove 160. Electronic components indexed to groove 166 are further indexed towards the end surface of number 1 arm section 118 by air blown in groove 166 from air grooves 168 and 170 and contact pin 167 which is established in groove 166. By this, with bulk feeder 100, multiple electronic components housed in a loose state are indexed to the supply position while arranged in a single line.

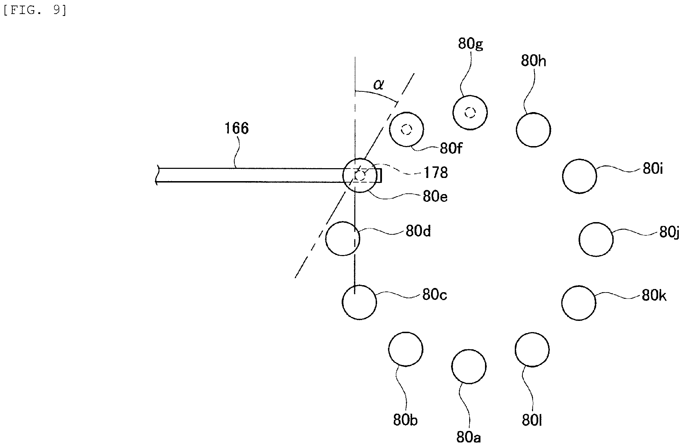

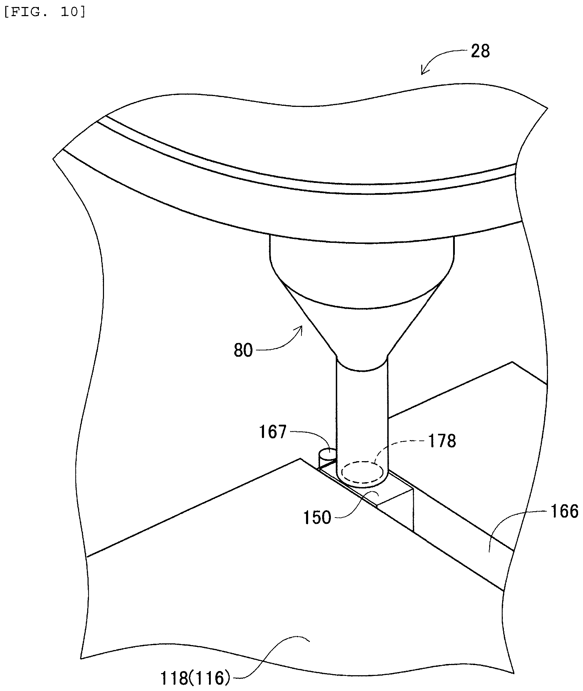

As shown in FIG. 9, bulk feeder 100 is fixed to mounting head 28 such that suction mouth 178 of suction nozzle 80e out of the multiple suction nozzles 80 positioned at the pickup position is positioned above the end of groove 166 which is its pickup position. By this, by suction nozzle 80e positioned at the pickup station being moved down by unit raising and lowering device 104, as shown in FIG. 10, electronic component 150 indexed to the supply position is picked up and held by suction mouth 178 of suction nozzle 80.

Also, the rotating direction by holding body rotating device 90 of suction nozzle 80e positioned at the pickup station, is generally the same as the widthwise direction of groove 166 at the supply position. In detail, as shown in FIG. 9, the deviation angle alpha between the rotating direction by holding body rotating device 90 of suction nozzle 80e, in other words, the direction (2-dash line) extending in a tangential line at nozzle 80e of the circumference on which are arranged multiple nozzles 80, and the widthwise direction (single dash line) of groove 166 at the supply position, is relatively small, and with this mounter 16 is 30 degrees. This, as described in detail below, is to appropriately correct the pickup position from bulk feeder 100 by suction nozzle 80e.

Also, mounter 16, as shown in FIG. 11, is equipped with control device 190. Control device 190 is equipped with controller 192 which is comprised mainly of a computer equipped with items such as CPU, ROM, and RAM; and multiple drive circuits 194 corresponding respectively to the above electromagnetic motors 46, 52, 54, and 134, board holding device 48, indexing device 76, positive and negative pressure supply device 84, holding body rotating device 90, unit rotating device 102, unit raising and lowering device 104, and solenoid 164. Also, the driving power for items such as the conveyance device and moving device are connected to controller 192 via each drive circuit 194, such that operation of items such as the conveyance device and moving device can be controlled. Also, image processing device 196 for processing data of images acquired by parts camera 96 and mark camera 98 is connected to controller 192, so that various types of data can be acquired from the image data.

### Mounting work by the electronic component mounter

With mounter 16, according to the configuration outlined above, it is possible to perform the mounting work of mounting electronic components onto a circuit board. To describe in detail, first, a circuit board is conveyed to the mounting work position by conveyor devices 40 and 42 and then the circuit board is held fixedly in that position. Next, mounting head 28 is moved above the circuit board by moving device 30, and an image of the circuit board is captured by mark camera 98. From that image the type of the circuit board and the holding position error of the circuit board due to conveyor devices 40 and 42 is acquired. Electronic components for that type of circuit board which was acquired are supplied by tape feeders 74 or bulk feeder 100. Further, those supplied electronic components are picked up and held by suction nozzles 80 of mounting head 28 at the mounting station or pickup station. However, in order to pick up and hold electronic components supplied by tape feeders 74, it is necessary to move mounting head 28 to the supply position of tape feeders 74 by moving device 30. Continuing, images of electronic components picked up and held by suction nozzles 80 are captured by parts camera 96 at the imaging station. From that image the holding position error of the electronic components is acquired. Further, mounting head 28 is moved to the mounting position above the circuit board by moving device 30, and the electronic components are mounted at the mounting station after suction nozzles 80 are rotated based on the error between the holding position of the electronic components and the circuit board.

### Correction of the pickup position and correction of the mounting position according to the suction nozzle

As given above, mounter 16 is configured to pick up and hold electronic components supplied by tape feeders 74 or bulk feeder 100 using suction nozzles 80, and to mount those picked up and held electronic components on a circuit board. With a mounter 16 configured as given above, it is very important that electronic components are picked up by suction nozzles 80 appropriately, so it is desirable to correct the pickup position so that the supply position of the electronic component and the pickup position by suction nozzle 80 are aligned.

To this end, in cases in which the pickup position by suction nozzle 80 and the supply position of the electronic component from tape feeder 74 deviate, the position of mounting head 28 is finely adjusted by moving device 30 such that the pickup position by suction nozzle 80 from tape feeder 74 is corrected. On the other hand, bulk feeder 100 is fixed to mounting head 28, and so it moved together with mounting head 28 by moving device 30. Due to this, in cases in which the pickup position by suction nozzle 80 and the supply position of the electronic component from bulk feeder 100 deviate, the pickup position by suction nozzle 80 from bulk feeder 100 is corrected by finely adjusting the rotational position of unit holding body 86 using holding body rotating device 90.

In detail, with mounter 16, as described above, the deviation angle of the widthwise direction of groove 166 at the supply position and the rotation direction of unit holding body 86 by holding body rotating device 90 is relatively small, and electronic components are stored inside groove 166 oriented so that the lengthwise direction thereof extends in the lengthwise direction of groove 166. Due to this, by finely adjusting the rotational position of holding body 86 using holding body rotating device 90, suction nozzles 80 are moved in the width direction of the electronic component and the pickup position is adjusted in the width direction of the electronic component. By this, the pickup position by suction nozzle 80 from bulk feeder 100 is corrected, and it is possible to appropriately pick up an electronic component by suction nozzle 80 from bulk feeder 100.

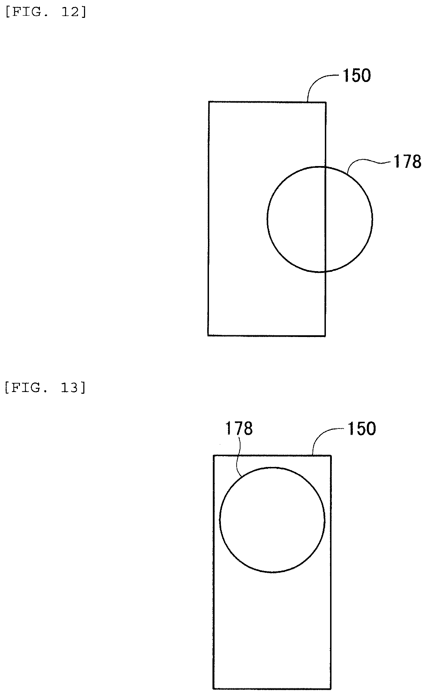

Specifically, for example, as shown in FIG. 12, in cases in which suction mouth 178 of suction nozzle 80 positioned at the pickup station is deviated with respect to electronic component 150 at the supply position in the widthwise direction of electronic component 150, even if the deviation is slight, only a portion of suction mouth 178 will be blocked by electronic component 150 and there is a risk that electronic component 150 cannot be picked up appropriately. For this, by adjusting the pickup position by suction nozzle 80 in the widthwise direction of electronic component 150 by adjusting the rotational position of unit holding body 86, electronic component 150 can be appropriately picked up by suction nozzle 80.

On the other hand, as shown in FIG. 13, even if suction mouth 178 of suction nozzle 80 positioned at the pickup station is somewhat deviated with respect to electronic component 150 at the supply position in the lengthwise direction of electronic component 150, suction mouth 178 is completely blocked by electronic component 150 depending on the length in the lengthwise direction of electronic component 150. In other words, with mounter 16, there is somewhat of a tolerance in the deviation between the pickup position by suction nozzle 80 and the supply position of bulk feeder 100 in the lengthwise direction of electronic component 150. Therefore, for cases in which the pickup position by suction nozzle 80 and the supply position of electronic component 150 from bulk feeder 100 deviate, it is possible to appropriately pick up electronic component 150 by suction nozzle 80 just by adjusting the pickup position by suction nozzle 80 in the widthwise direction of electronic component 150 using holding body rotating device 90.

From the viewpoint of adjusting the pickup position by suction nozzle 80 in the widthwise direction of the electronic component, it is desirable for the deviation angle between the widthwise direction of groove 166 at the supply position and the rotation direction of unit holding body 86 by holding body rotating device 90 to be small, and it is desirable for those two directions to be aligned. In other words, with mounter 16, as shown in FIG. 9, groove 166 is formed below suction nozzle 80e, and the configuration is such that an electronic component is picked up and held by that suction nozzle 80e, and groove 166 is formed below suction nozzle 80d and it is possible to appropriately perform correction of the pickup position by picking up and holding an electronic component with that suction nozzle 80d.

However, as described above, with mounting head 28, mounting units 82 are moved up and down according to the rotation of unit holding body 86 such that they move up from suction nozzle 80a positioned at the mounting station until suction nozzle 80e positioned at the pickup station, whereby that suction nozzle 80e and the four suction nozzles 80f to 80i downstream thereof are positioned at the highest point. In other words, suction nozzle 80e does not move down even if unit holding body 86 is rotated, but suction nozzle 80d moves up/down according to the rotation of unit holding body 86. Therefore, if the configuration is such that groove 166 is formed below suction nozzle 80d and an electronic component is picked up and held by that suction nozzle 80d, the suction nozzle moves up/down according to the rotation of unit holding body 86 when correcting the pickup position, and there is a risk that the pickup position cannot be corrected appropriately. Taking account of such circumstances, with mounter 16, groove 166 is formed below suction nozzle 80e, and the configuration is such that an electronic component can be pickup up and held by that suction nozzle 80e.

Also, if the pickup position of suction nozzle 80e positioned at the pickup station is corrected by adjustment of the rotational position of unit holding body 86, suction nozzle 80a positioned at the mounting station is also moved, and the mounting position by suction nozzle 80a also moves undesirably. In other words, the mounting position by suction nozzle 80a deviates from the position at which mounting of the electronic component should be performed on the circuit board due to the correction of the pickup position. Therefore, with the present mounter 16, after the pickup position of an electronic component from bulk feeder 100 is corrected, the mounting position by suction nozzle 80a is corrected by the position of mounting head 28 being finely adjusted by moving device 30. By this, it is possible to appropriately maintain the pickup position of electronic components from bulk feeder 100 and the mounting position of the electronic components onto a circuit board.

Pickup position correction section (refer to FIG. 11) 200 as a functional section for correcting the pickup position of electronic components from bulk feeder 100, and mounting position correction section (refer to FIG. 11) 202 as a functional section for correcting the mounting position of electronic components onto a circuit board are provided on controller 192 of control device 190.

### Shape of the suction mouth of the suction nozzles

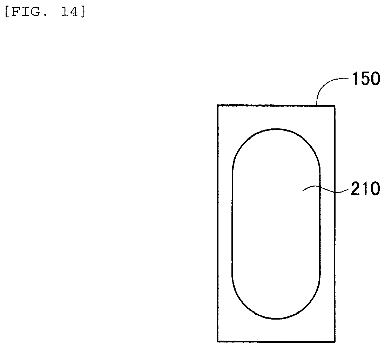

Recently, in order to perform pickup of electronic components appropriately, there are cases of suction nozzles which have a suction mouth with a large suction area being used. Specifically, as shown in FIG. 14, there are cases of suction nozzles with an elliptical shaped suction mouth 210 being used. With suction nozzles such as this which have a suction mouth 210 with a large suction area, it is possible to increase the air suction power, making it possible to pick up electronic components 150 appropriately.

However, when a suction nozzle which has a suction mouth 210 with the above shape, there is a risk that electronic component 150 cannot be picked up appropriately. In detail, unit rotating device 102 is provided on mounting head 28 in order to adjust the holding orientation of an electronic component when mounting an electronic component onto a circuit board. The configuration of unit rotating device 102 provided on mounting head 28 should be simple, so the configuration is such that multiple mounting units 82 are rotated about their own axis at the same time, and all the mounting units 82 are rotated by the movement of unit rotating device 102. Due to this, not only suction nozzle 80a positioned at the mounting station, but also suction nozzle 80e positioned at the pickup station, rotates.

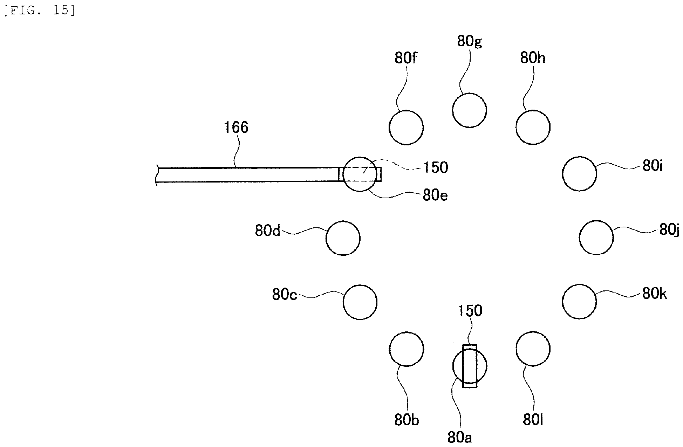

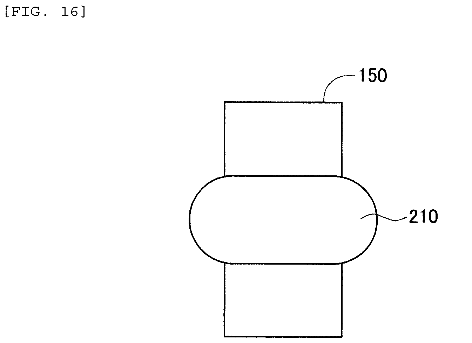

Specifically, for example, the electronic component being held by suction nozzle 80a positioned at the mounting station should be mounted on a circuit board in the state shown in FIG. 15, but when unit rotating device 102 is moved, nozzle 80e positioned at the pickup station also rotates. If this nozzle 80e has a suction mouth 210 with the above shape, the suction mouth 210 will rotate to the state shown in FIG. 16 based on the rotation of suction nozzle 80e. As can be understood from the figure, when an elliptical suction mouth 210 is rotated, a section of the suction mouth 210 is no longer blocked by electronic component 150, and electronic component 150 can no longer be picked up and held appropriately due to factors such as air leaks.

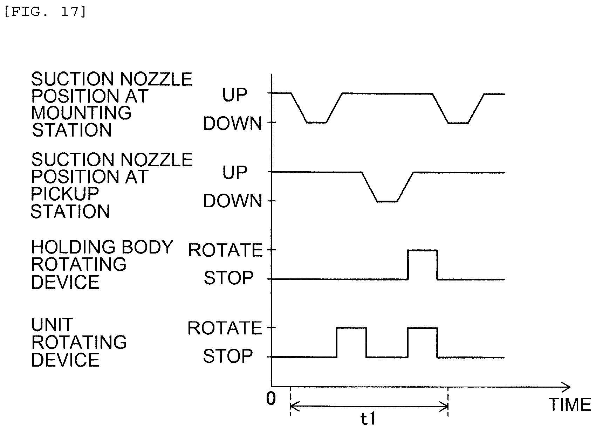

However, by rotating again suction mouth 210 rotated to the state shown in FIG. 16 using unit rotating device 102, it is possible to return the suction mouth 210 to the state shown in FIG. 14. This is described specifically below using the chart shown in FIG. 17. First, electronic component 150 in the state shown in FIG. 15 is mounted onto a circuit board by the downward movement of suction nozzle 80a positioned at the mounting station. Here, as shown in FIG. 16, suction mouth 210 of suction nozzle 80e positioned at the pickup station is deviated with respect to electronic component 150 such that electronic component 150 cannot be picked up and held appropriately.

Due to this, when mounting of the electronic component onto a circuit board is complete, unit rotating device 102 is moved and suction mouth 210 in the state shown in FIG. 16 is rotated to the state shown in FIG. 14. By this, the deviation between suction mouth 210 of suction nozzle 80e positioned at the pickup station and electronic component 150 is resolved. Then, suction nozzle 80e positioned at the pickup station is moved down to pick up and hold an electronic component appropriately by suction mouth 210.

Continuing, mounting work should be performed at the mounting station, so holding body rotating device 90 is moved such that unit holding body 86 is rotated. Here, the next electronic component 150 to be mounted should be rotated to the state shown in FIG. 15, so unit rotating device 102 is rotated. Then, electronic component 150 in the state shown in FIG. 15 is mounted onto a circuit board by the downward movement of suction nozzle 80a positioned at the mounting station. In this way, when suction nozzle 80 has an elliptical suction mouth 210, it is possible, as well as pickup up and holding an electronic component appropriately, to mount electronic component 150 in the state shown in FIG. 15 onto a circuit board by controlling the operation of items such as holding body rotating device 90 and unit rotating device 102.

On the other hand, consider the case for mounting work and pickup work in which suction nozzle 80 which has a round suction mouth 178, not an elliptical suction mouth 210, is used. Because there is no directionality for round suction mouth 178, no deviation occurs between suction mouth 178 and electronic component 150 even if mounting units 82, in other words, suction nozzles 80, are rotated by the movement of unit rotating device 102. Due to this, even if unit rotating device 102 is moved when mounting an electronic component onto a circuit board, it is not necessary to move unit rotating device 102 in order to pick up an electronic component. In other words, after completing mounting work, because it is not necessary to move unit rotating device 102 as preparation for pickup work, it is possible to perform mounting work and pickup work at the same time.

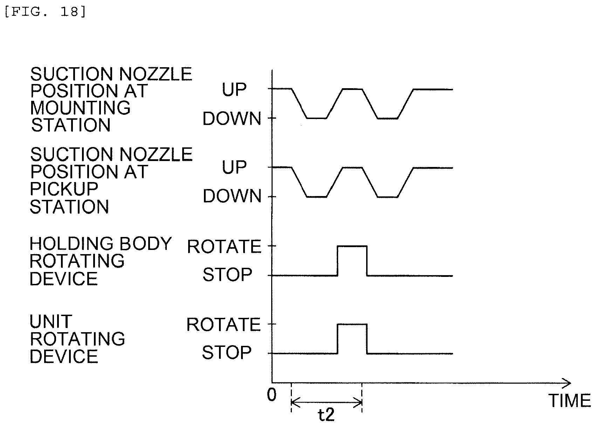

Specifically, as shown in FIG. 18, electronic component 150 in the state shown in FIG. 15 is mounted onto a circuit board by the downward movement of suction nozzle 80a positioned at the mounting station. Here, because suction mouth 178 of pickup nozzle 80e positioned at the pickup station is not deviated with respect to electronic component 150, it can be moved down at the same time as suction nozzle 80a positioned at the mounting station is moved down. By this, mounting work and pickup work can be performed at the same time. And, after these two works are completed, the next mounting work and pickup work should be performed, so holding body rotating device 90 is moved such that unit holding body 86 is rotated. Here, the next electronic component 150 to be mounted should be rotated to the state shown in FIG. 15, so unit rotating device 102 is rotated. Then, mounting work and pickup work are performed at the same time by the downward movement of suction nozzles 80a and 80e positioned at the mounting station and the pickup station.

By using suction nozzles 80 which have a round suction mouth 178 like this, it is possible to perform mounting work and pickup work at the same time, which makes it possible to perform mounting work efficiently. This is clear from the fact that the time t2 (refer to FIG. 18) required for one mounting operation by suction nozzle 80 which has a round suction mouth 178 is half or less than time t1 (refer to FIG. 17) required for one mounting operation by suction nozzle 80 which has an elliptical suction mouth 210, and with mounter 16, suction nozzles 80 which have a round suction mouth 178 are used.

In the above embodiment, electronic component mounter 16 is an example of an electronic component mounter and mounting head 28, moving device 30, board holding device 48, bulk feeder 100, and control device 190 which comprise electronic component mounter 16 are respectively an example of a mounting head, a moving device, a board holding device, a bulk feeder, and a control device. Suction nozzle 80, unit holding body 86, holding body rotating device 90, rollers 92, unit rotating device 102, and suction mouth 178 which comprise mounting head 28 are respectively an example of a suction nozzle, a holding body, a holding body rotating device, an up/down movement mechanism, a nozzle rotating device, and a suction mouth. Storage section 156, and groove 142 and groove 166 which comprise bulk feeder 100 are respectively an example of a storage section, and a supply passage. Pickup position correction section 200 and mounting position correction section 202 which comprise control device 190 are respectively an example of a pickup position correction section and a mounting position correction section. Also, the pickup station is an example of a pickup position, and the mounting station is an example of a mounting position.

Further, the present invention is not limited to the above example embodiment, and various changed or improved methods of embodiment, as long as they fall under the scope of the appended claims, are possible based on the knowledge of someone skilled in the art. Specifically, for example, in the above embodiment, the location in which pickup nozzle 80e is positioned in FIG. 4 is the pickup station, and the location in which pickup nozzle 80a is positioned is the mounting station, but it is possible to set each station at any position. However, for the pickup station, the positional relationship given above with the supply position of bulk feeder 100 must be satisfied.

Also, in the above embodiment, bulk feeder 100 is able to be moved together with mounting head 28 by moving device 30 by being fixed to head body 88 of mounting head 28, however, it is also acceptable for it to be fixed to a section other than head body 88 of mounting head 28. However, fixing bulk feeder 100 to a moving section is not preferable, so bulk feeder 100 is not fixed to items such as unit holding body 86. Also, it is acceptable if bulk feeder 100 is connected directly or indirectly to mounting head 28, so it is also acceptable to fixedly connect it to mounting head 28 via slider 50 by bulk feeder 100 being fixed to slider 50.

### Symbol descriptions

16: Electronic component mounter; 28: Mounting head; 30: Moving device; 48: Board holding device; 80: Suction nozzle; 86: Unit holding body (holding body); 90: Holding body rotating device; 92: Roller (up/down moving mechanism); 100: Bulk feeder; 102: Unit rotating device (nozzle rotating device); 142: Groove (supply passage); 156: Storage section; 166: Groove (supply passage); 178: Suction mouth; 190: Control device; 200: Pickup position correction section; 202: Mounting position correction section

## Claims

1. An electronic component mounter (16) comprising:
a board holding device (48) for fixedly holding a circuit board;
a mounting head (28) which has multiple suction nozzles (80) for picking up and holding electronic components;
a moving device (30) for moving the mounting head (28) to any position; and
a bulk feeder (100) equipped with a storage section (156) for storing multiple electronic components in a loose state and a supply passage (142) for guiding the electronic components stored in that storage section (156) to an electronic component supply position while arranged in a single line which is configured to supply electronic components to the supply position;
wherein the mounting head (28) has a holding body (86) for holding those multiple suction nozzles (80) arranged on a circumference, and a holding body rotating device (90) for rotating the holding body (86) with the center of the circumference as the axis center, and
the electronic components are supplied by the bulk feeder (100),
**characterized in that**
the bulk feeder (100) is connected to the mounting head (28) and is capable of being moved to any position together with the mounting head (28) by the moving device (30), such that an electronic component positioned at a pickup position which is a specified position on the circumference of the multiple suction nozzles (80) can be picked up and held from the supply position of the bulk feeder (100) connected to the mounting head (28), and
the electronic component mounter (16) further comprises a control device (190) for controlling operation of the holding body rotating device (90), wherein that control device (190) has a pickup position correction section (200) for controlling operation of the holding body rotating device (90) such that, from among the multiple suction nozzles (80), the suction mouth (178) of the suction nozzle (80) which is positioned at the pickup position is positioned above the supply position,
wherein the bulk feeder (100) is connected to the mounting head (28) such that the widthwise direction at the supply position of the supply passage (142) and the direction extending in a tangential line at the pickup position of the circumference are aligned, or where the directional deviation of those two is less than 45 degrees.

2. The electronic component mounter (16) according to claim 1 wherein, from among the multiple suction nozzles (80), a suction nozzle (80) positioned at a position other than the pickup position is configured to mount an electronic component on a circuit board, and the control device (190) has a mounting position correction section (202) for correcting the mounting position of electronic components on the circuit board by being capable of controlling operation of the moving device (30) and controlling the operation of the moving device (30).

3. The electronic component mounter (16) according to claim 2 which is configured to be able to perform pickup work at the pickup position and mounting work at a position other than the pickup position at the same time.

4. The electronic component mounter (16) according to any of claims 1 to 3 wherein the mounting head (28) has a nozzle rotating device (102) for rotating each of the multiple suction nozzles (80) about the center axis of itself at the same time, and the suction mouth of each of the multiple suction nozzles (80) is round.

5. The electronic component mounter (16) according to any of claims 1 to 4 wherein, from among the multiple suction nozzles (80), a suction nozzle (80) positioned at a mounting position which is a position other than the pickup position is configured to mount an electronic component on a circuit board, and the mounting head (28) has an up/down moving mechanism (92) which moves each of the multiple suction nozzles (80) up from the mounting position to the pickup position according to the rotation of the holding body rotating device (90) and limits the up/down movement at the pickup position.

6. The electronic component mounter (16) according to claim 5 wherein the bulk feeder (100) is connected to the mounting head (28) such that the widthwise direction at the supply position of the supply passage (142) and the direction extending in a tangential line at the position on the side of the mounting position from the pickup position of the circumference are aligned.

## Patentansprüche

1. Montagevorrichtung für elektronische Komponenten (16), mit:
einer Platinenhalteeinrichtung (48) zum fixierten Halten einer Leiterplatte;
einem Montagekopf (28), der mehrere Saugdüsen (80) zum Aufnehmen und Halten elektronischer Komponenten hat;
einer Bewegungseinrichtung (30) zum Bewegen des Montagekopfs (28) zu einer Position; und
einer Volumenzuführeinheit (100), die mit einem Lagerabschnitt (156) zur Lagerung mehrerer elektronischer Komponenten in losem Zustand und mit einem Zufuhrdurchgang (142) zum Führen der in dem Lagerabschnitt (156) gelagerten elektronischen Komponenten zu einer Zufuhrposition für elektronische Komponenten, die in einer einzigen Linie angeordnet sind, versehen ist, wobei der Durchgang ausgebildet ist, elektronische Komponenten an der Zufuhrposition bereitzustellen;
wobei der Montagekopf (28) einen Haltekörper (86) zum Halten der mehreren Saugdüsen (80), die auf einem Umfang angeordnet sind, und zum Halten einer Körperdreheinrichtung (90) zum Drehen des Haltekörpers (86) aufweist, wobei der Mittelpunkt des Umfangs die Drehachse ist, und
wobei die elektronischen Komponenten durch die Volumenzuführeinheit (100) zugeführt werden,
**dadurch gekennzeichnet, dass**
die Volumenzuführeinheit (100) mit dem Montagekopf (28) verbunden und ausgebildet ist, zusammen mit dem Montagekopf (28) durch die Bewegungseinrichtung (30) zu einer Position bewegt zu werden derart, dass eine elektronische Komponente, die an der Aufnahmeposition positioniert ist, die eine spezifizierte Position auf dem Umfang der mehreren Saugdüsen (80) ist, aus der Aufnahmeposition der Volumenzuführeinheit (100), die mit dem Montagekopf (28) verbunden ist, aufgenommen und gehalten werden kann, und
die Montagevorrichtung für elektronische Komponenten (16) ferner eine Steuereinrichtung (190) zur Steuerung des Betriebs der Haltekörperdreheinrichtung (90) aufweist, wobei die Steuereinrichtung (190) einen Aufnahmepositionskorrekturblock (200) zur Steuerung des Betriebs der Haltekörperdreheinrichtung (90) derart hat, dass von den mehreren Saugdüsen (80) die Saugöffnung (178) derjenigen Saugdüse (80), die an der Aufnahmeposition positioniert ist, über der Zuführposition positioniert wird,
wobei die Volumenzuführeinheit (100) mit dem Montagekopf (28) derart verbunden ist, dass die Breitenrichtung an der Zuführposition des Zuführdurchgangs (142) und die Richtung, die in einer tangentialen Linie an der Aufnahmeposition des Umfangs verläuft, zueinander ausgerichtet sind, oder eine Richtungsabweichung dieser zwei Richtungen kleiner als 45° ist.

2. Montagevorrichtung für elektronische Komponenten (16) nach Anspruch 1, wobei von den mehreren Saugdüsen (80) eine Saugdüse (80), die an einer Position positioniert ist, die nicht die Aufnahmeposition ist, so ausgebildet ist, dass eine elektronische Komponente auf einer Leiterplatte montierbar ist, und wobei die Steuereinrichtung (190) einen Montagepositionskorrekturblock (202) aufweist, um die Montageposition elektronischer Komponenten auf der Leiterplatte zu korrigieren durch In-der-Lage-Sein, den Betrieb der Bewegungseinrichtung (30) zu steuern, und durch Steuern des Betriebs der Bewegungseinrichtung (30).

3. Montagevorrichtung für elektronische Komponenten (16) nach Anspruch 2, die ausgebildet ist, um in der Lage zu sein, einen Aufnahmevorgang an der Aufnahmeposition und einen Montagevorgang an einer Position, die nicht die Aufnahmeposition ist, zur gleichen Zeit auszuführen.

4. Montagevorrichtung für elektronische Komponenten (16) nach einem der Ansprüche 1 bis 3, wobei der Montagekopf (28) eine Düsendreheinrichtung (102) zum gleichzeitigen Drehen jeweils der mehreren Saugdüsen (80) um die Mittelachse aufweist, und wobei die Saugöffnung jeder der mehreren Saugdüsen (80) rund ist.

5. Montagevorrichtung für elektronische Komponenten (16) nach einem der Ansprüche 1 bis 4, wobei von den mehreren Saugdüsen (80) eine Saugdüse (80), die an einer Montageposition positioniert ist, die eine Position ist, die nicht die Aufnahmeposition ist, ausgebildet ist, eine elektronische Komponente auf einer Leiterplatte zu montieren, und der Montagekopf (28) einen Auf/Ab-Bewegungsmechanismus (92) aufweist, der jede der mehreren Saugdüsen (80) von der Montageposition aufwärts zu der Aufnahmeposition entsprechend der Drehung der Haltekörperdreheinrichtung (90) bewegt und die Auf/Ab-Bewegung an der Aufnahmeposition begrenzt.

6. Montagevorrichtung für elektronische Komponenten (16) nach Anspruch 5, wobei die Volumenzuführeinheit (100) mit dem Montagekopf (28) derart verbunden ist, dass die Breitenrichtung an der Zuführposition des Zuführdurchgangs (142) und die Richtung, die in einer tangentialen Linie an der Position auf der Seite der Montageposition ausgehend von der Aufnahmeposition des Umfangs verläuft, zueinander ausgerichtet sind.

## Revendications

1. Machine de montage de composants électroniques (16) comprenant :
un dispositif de maintien de carte (48) destiné à maintenir fixe une carte à circuit imprimé,
une tête de montage (28) qui comporte de multiples buses d'aspiration (80) destinées à prélever et à maintenir des composants électroniques,
un dispositif de déplacement (30) destiné à déplacer la tête de montage (28) vers une position quelconque, et
un dispositif d'alimentation en vrac (100) muni d'une section de stockage (156) permettant de stocker de multiples composants électroniques en vrac et d'un passage d'alimentation (142) permettant de guider les composants électroniques stockés dans la section de stockage (156) jusqu'à une position de délivrance de composant électronique lorsqu'ils sont disposés en une seule ligne qui est configurée pour fournir les composants électroniques jusqu'à la position d'alimentation,
dans laquelle la tête de montage (28) comporte un corps de maintien (86) destiné à retenir les multiples buses d'aspiration (80) disposées sur un cercle, ainsi qu'un dispositif de rotation de corps de maintien (90) destiné à faire tourner le corps de maintien (86) autour du centre de la circonférence pris comme axe central, et
les composants électroniques délivrés par le dispositif d'alimentation en vrac (100),
**caractérisée en ce que** :
le dispositif d'alimentation en vrac (100) est relié à la tête de montage (28) et peut être déplacé jusqu'à une position quelconque en même temps que la tête de montage (28) par le dispositif de déplacement (30) de sorte à ce qu'un composant électronique placé sur une position de prélèvement, qui est une position spécifiée sur la circonférence des multiples buses d'aspiration (80), puisse être prélevé et maintenu à partir de la position d'alimentation du dispositif d'alimentation en vrac (100) relié à la tête de montage (28), et
la machine de montage de composants électroniques (16) comprend en outre un dispositif de commande (190) destiné à piloter le fonctionnement du dispositif de rotation de corps de maintien (90), ce dispositif de commande (190) comportant une section de correction de position de prélèvement (200) destinée à piloter le fonctionnement du dispositif de rotation de corps de maintien (90) de sorte à ce que, parmi les multiples buses d'aspiration (80), l'orifice d'aspiration (178) de la buse d'aspiration (80), qui est placée à la position de prélèvement, soit placé au-dessus de la position d'alimentation,
dans laquelle le dispositif d'alimentation en vrac (100) est relié à la tête de montage (28) de sorte à ce que la direction de la largeur au niveau de la position d'alimentation du passage d'alimentation (142) et la direction s'étendant selon une droite tangentielle au niveau de la position de prélèvement de la circonférence soient alignées, ou bien que l'écart de ces deux directions soit inférieur à 45 degrés.

2. Machine de montage de composants électroniques (16) selon la revendication 1, dans laquelle, parmi les multiples buses d'aspiration (80), une buse d'aspiration (80), placée sur une position différente de la position de prélèvement, est configurée pour monter un composant électronique sur une carte à circuit imprimé, et le dispositif de commande (190) comporte une section de correction de position de montage (202) permettant de corriger la position de montage de composants électroniques sur la carte à circuit imprimé en pouvant piloter le fonctionnement du dispositif de déplacement (30) et en pilotant le fonctionnement du dispositif de déplacement (30).

3. Machine de montage de composants électroniques (16) selon la revendication 2, qui est configurée pour pouvoir effectuer en même temps une tâche de prélèvement à la position de prélèvement et une tâche de montage à une position différente de la position de prélèvement.

4. Machine de montage de composants électroniques (16) selon l'une quelconque des revendications 1 à 3, dans laquelle la tête de montage (28) comporte un dispositif de rotation de buse (102) permettant de faire tourner en même temps chacune des multiples buses d'aspiration (80) autour de son propre axe central, et dans laquelle l'orifice d'aspiration de chacune des multiples buses d'aspiration (80) est rond.

5. Machine de montage de composants électroniques (16) selon l'une quelconque des revendications 1 à 4, dans laquelle, parmi les multiples buses d'aspiration (80), une buse d'aspiration (80) placée sur une position de montage, qui est une position différente de la position de prélèvement, est configurée pour monter un composant électronique sur une carte à circuit imprimé, et la tête de montage (28) comporte un mécanisme de déplacement vers le haut/vers le bas (92) qui déplace chacune des multiples buses d'aspiration (80) vers le haut à partir de la position de montage jusqu'à la position de prélèvement en fonction de la rotation du dispositif de rotation de corps de maintien (90) et limite le mouvement vers le haut/vers le bas sur la position de prélèvement.

6. Machine de montage de composants électroniques (16) selon la revendication 5, dans laquelle le dispositif d'alimentation en vrac (100) est relié à la tête de montage (28) de sorte à ce que soient alignées la direction de la largeur au niveau de la position d'alimentation du passage d'alimentation (142) et la direction s'étendant selon une droite tangentielle à la position sur le côté de la position de montage à partir de la position de prélèvement de la circonférence.
